# EUROPÄISCHE PATENTSCHRIFT

(11) **EP 0 471 934 B1**
(45) Veröffentlichungstag und Bekanntmachung des Hinweises auf die Patenterteilung: **25.09.1996**
(21) Anmeldenummer: 91109566.9
(22) Anmeldetag: 11.06.1991
(51) Int. Cl.: H05K 7/14

(54) **Steck- und Ziehhilfe**
Insertion and extraction means
Moyens d'insertion et d'extraction

(30) Priorität: 23.08.1990 DE 9012143 U
(43) Veröffentlichungstag der Anmeldung: 26.02.1992
(73) Patentinhaber: Knürr Mechanik für die Elektronik AG, D-81829 München (DE)
(72) Erfinder: Simon, Peter, W-8000 München 70 (DE)
(74) Vertreter: Heim, Hans-Karl, Dipl.-Ing.

(56) Entgegenhaltungen:
- EP-A- 0 272 521
- EP-A- 0 293 215
- EP-A- 0 357 308
- EP-A- 0 369 025
- DE-A- 3 711 341
- US-A- 4 875 867

## Beschreibung

Die Erfindung betrifft eine Steck- und Ziehhilfe, insbesondere für den Einbau elektronischer Baugruppen und Bausysteme, mit einem Formteil, das ein Verriegelungs- und ein Griffteil aufweist.

Steck- und Ziehhilfen sind neben der Frontplatte und dem Halter Teile des Frontsystems von Einbausystemen, die der Aufnahme von Baugruppen dienen und Anwendung in der Daten- und Meßtechnik, Medizintechnik, Nachrichtentechnik, Steuerungs- und Regelungstechnik und anderen Bereichen finden.

In der Fachbranche sind Steck- und Ziehhilfen der gattungsgemäßen Art bekannt. Diese aus Kunststoff bestehenden Steck- und Ziehhilfen weisen ein Verriegelungsteil zur formschlüssigen Verriegelung der Baugruppen an die Verbindungsschienen des Baugruppenträgers sowie ein Griffteil auf, an dem beim Ein- und Ausbau der Steckverbinder die Steck- und Ziehkräfte angesetzt werden, um dann durch Hebelwirkung übersetzt zu werden.

Es hat sich in der praktischen Handhabung gezeigt, daß das Stecken und Ziehen der Baugruppen mit einer derart ausgebildeten Steck- und Ziehhilfe relativ schwierig und umständlich ist. Insbesondere bei Baugruppen mit hoher PIN-Dichte reicht die vorhandene Angriffsfläche des Griffteils oft nicht aus, um die dabei auftretenden hohen Steck- und Ziehkräfte zu überwinden.

Aus der US-PS 4,875,867 ist eine Steck- und Ziehvorrichtung mit einem Formteil bekannt, welches ein Verriegelungsteil und ein Griffteil mit einer ausziehbaren Verlängerung aufweist. Die Verlängerung ist in kulissenartigen Führungen an der Außenseite des Griffteiles geführt und mit einem Griffbereich versehen. Eine Betätigung erfolgt über den Griffbereich der Verlängerung, wobei Haltestifte, die in den kulissenartigen Führungen gehalten werden und mit diesen zusammenwirken, die Verlängerung am Griffteil halten und den Ausziehvorgang begrenzen.

Diese bekannte Steck- und Ziehhilfe weist eine materialintensive und fertigungstechnisch aufwendige Ausbildung auf und ist außerdem durch die außenseitige kulissenartige Führung relativ störanfällig.

Der Erfindung liegt die **Aufgabe** zugrunde, eine Steck- und Ziehhilfe zu schaffen, die besonders einfach aufgebaut, kostengünstig herstellbar und montierbar ist und sowohl bei geringen als auch hohen PIN-Dichten ein präzises und sicheres Stecken und Ziehen der Baugruppen gewährleistet.

Erfindungsgemäß wird die Aufgabe durch die kennzeichnenden Merkmale des Anspruchs 1 gelöst. Zweckmäßige und vorteilhafte Ausgestaltungen sind in der Figurenbeschreibung und in den Unteransprüchen beschrieben.

Erfindungsgemäß weist eine Steck- und Ziehhilfe mit einem Formteil, das von einem Verriegelungsteil und einem Griffteil mit einer in einer Ausnehmung des Griffteils aufgenommenen, ein- und ausziehbaren Verlängerung gebildet ist, eine Verlängerung auf, an deren oberen Ende ein walzenförmiger Griff ausgebildet ist. Der walzenförmige Griff ist im eingeschobenen Zustand der Verlängerung in einer etwa halbkreisförmigen Vertiefung des Griffteils formschlüssig aufgenommen. Die ausziehbare Verlängerung ist in beiden Endpositionen mittels Rastelementen gesichert, wobei die Rastelemente in komplementär angeordneten Ausnehmungen einer Führung der Verlängerung einrasten.

Indem das Griffteil mit einem an einer ein- und ausschiebbaren Verlängerung ausgebildeten, walzenförmigen Griff versehen ist und mit diesem Griff im eingeschobenen Zustand in einer komplementären Ausnehmung des Griffteils ruht, kann die Angriffsfläche im Bedarfsfall jederzeit vergrößert werden. Im eingeschobenen Zustand, d.h. nach dem Steck- oder Ziehvorgang, fügt sich die Verlängerung nahezu vollständig und formschlüssig in das Griffteil ein. Ein freies Sichtfeld, beispielsweise auf Dioden oder andere Anzeigeelemente, bleibt erhalten.

Ein wesentlicher Vorteil besteht darin, daß durch die ein- und ausschiebbare Verlängerung, die ergonomisch gestaltet und mittels Rastelementen gesichert ist, eine fakultativ betätigbare Verlängerung am Griffteil geschaffen wurde, durch welche die Angriffsfläche nur bei Bedarf vergrößert und die Hebelwirkung verstärkt werden kann. Das Stecken und Ziehen der Baugruppen wird einfacher und durch die gesicherten Rastelemente und Rastbereiche besonders sicher. Das Stecken und Ziehen kann mit geringerem Kraftaufwand erfolgen. Wenn die Steck- und Ziehhilfe nicht betätigt wird, ist eine formschlüssige Aufnahme gewährleistet. Ein außerordentlich günstiger ästhetischer Eindruck ist gegeben, wenn das obere Ende der Verlängerung abgerundet ist und sich in eine Vertiefung im Griffteil einfügt. Dadurch bleibt ein freies Sichtfeld auf Anzeigeelemente oder Beschriftungen erhalten.

Vorzugsweise erstreckt sich die erfindungsgemäße Verlängerung über die gesamte Breite des Griffteils. Es ist aber auch eine stabförmige Ausbildung möglich. Die Ausnehmung im Griffteil zur Aufnahme der Verlängerung ist dann entsprechend ausgeformt, so daß eine sichere und stabile Führung der Verlängerung gewährleistet ist.

Es ist zur verbesserten Handhabung zweckmäßig, das obere Ende der Verlängerung abgesetzt auszubilden und so abzurunden, daß es sich in die Ausnehmung des Griffelementes einfügt, wenn es nach dem Ein- und Ausbau der Baugruppen wieder eingeschoben wird.

Ferner ist es möglich, den Rastbereich am äußeren Umfang der Verlängerung mittels punkt- oder ringförmiger Erhebungen auszubilden, die in komplementäre Vertiefungen in der Führung des Griffteils einrasten können. Zweckmäßigerweise ist dann die Verlängerung zumindest im Rastbereich hohl ausgebildet, um die erforderliche Elastizität bzw. Spannung zu erreichen.

Weitere Ausgestaltungen des Rastbereichs bzw. der Rastelemente liegen im Rahmen der Erfindung. Beispielsweise können die Erhebungen im unteren und oberen Bereich der Ausnehmung angeordnet sein, während analog dazu die Verlängerung im oberen und unteren Bereich entsprechend geformte Löcher aufweist, in die die federnd gelagerten Erhebungen einrasten können.

Obwohl die Steck- und Ziehhilfe sowie die Verlängerung vorzugsweise aus einem metallischen Material oder Druckguß bestehen, könnten auch harte Kunststoffmaterialien genutzt werden.

Die Verlängerung kann alternativ formschlüssig im Außenbereich, z.B. in seitlichen Nuten, geführt sein, wobei jedoch stets ein Fluchten mit den Seitenflächen der Steck-und Ziehhilfe vorhanden ist.

Die erfindungsgemäße Steck- und Ziehhilfe ist durch einen besonders einfachen, kostengünstigen Aufbau gekennzeichnet. Herstellung und Montage sind mit außerordentlich geringen Kosten verbunden, und die Störanfälligkeit ist äußerst gering.

Die Erfindung soll nachstehend an einem Ausführungsbeispiel näher erläutert werden. Es zeigen:

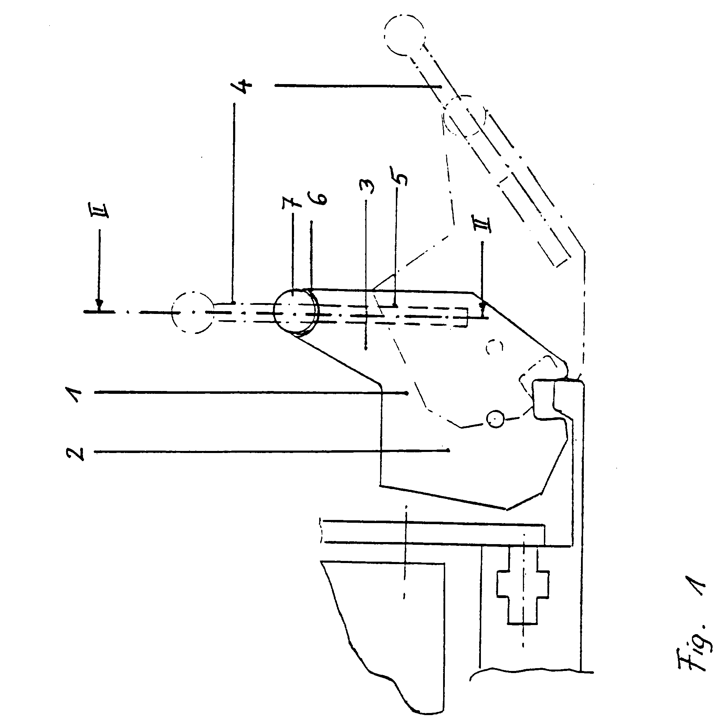

- Fig. 1: eine Seitenansicht der erfindungsgemäßen Steck-und Ziehhilfe und
- Fig. 2: einen Schnitt nach Linie II-II in Fig. 1.

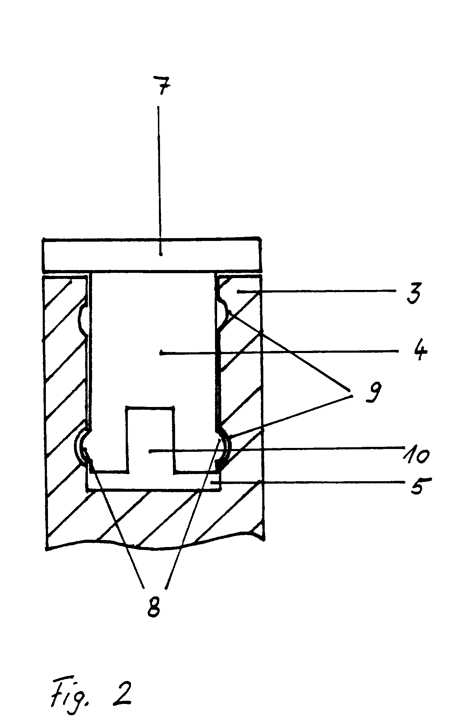

Die schematisch dargestellte Steck- und Ziehhilfe stellt im wesentlichen ein Metallformteil 1 dar, das aus einem Verriegelungsteil 2, auf das nicht näher eingegangen wird, und einem Griffteil 3 besteht. Die erfindungsgemäße Verlängerung 4 befindet sich im eingeschobenen Zustand formschlüssig in einer im Griffteil 3 komplementär ausgebildeten Ausnehmung 5, die damit die Führung der Verlängerung gewährleistet. Die ein- und ausschiebbare Verlängerung 4 reicht nahezu über die gesamte Breite des Griffteils 3 (Fig. 2). Das obere Ende ist abgesetzt und walzenförmig ausgebildet.

Der komplementäre obere Bereich des Griffteils weist eine halbkreisförmige Vertiefung 6 auf, in die der walzenförmige Griff 7 der Verlängerung 4 im eingeschobenen Zustand formschlüssig ruht.

Im gewählten Ausführungsbeispiels sind als Rastelemente im unteren Bereich der Verlängerung 4 punktförmige Erhebungen 8 und analog dazu im unteren und oberen Bereich der Ausnehmung 5 des Griffteils 3 Vertiefungen 9 angebracht, so daß die Verlängerung 4, die zudem in diesem Rastbereich einen Hohlraum 10 aufweist, sowohl im eingeschobenen als auch ausgeschobenen Zustand sicher positioniert ist.

## Patentansprüche

1. Steck- und Ziehhilfe, insbesondere für den Einbau elektronischer Baugruppen in Bausysteme, mit einem Verriegelungsteil (2), einem Griffteil (3) und einer Verlängerung (4), bei dem das Verriegelungsteil (2) und das Griffteil (3) ein Formteil bilden und das Griffteil (3) eine Ausnehmung (5) mit einer ein- und ausziehbaren Verlängerung (4) aufweist, welche im eingeschobenen Zustand von der komplementär ausgebildeten Ausnehmung (5) aufgenommen ist,
dadurch **gekennzeichnet,**
daß die Verlängerung (4) an einem oberen Ende einen walzenförmigen Griff (7) aufweist, welcher im eingeschobenen Zustand in einer etwa halbkreisförmigen Vertiefung (6) des Griffteils (3) formschlüssig aufgenommen ist, und
daß die ausziehbare Verlängerung (4) in beiden Endpositionen mittels Rastelemente (8) gesichert ist, welche in komplementär angeordnete Ausnehmungen (9) der Führung der Verlängerung (4) einrasten.

2. Steck- und Ziehhilfe nach Anspruch 1,
dadurch **gekennzeichnet,**
daß die Verlängerung (4) nahezu über die gesamte Breite des Griffteils (3) reicht.

3. Steck- und Ziehhilfe nach Anspruch 1 oder 2,
dadurch **gekennzeichnet,**
daß die Verlängerung (4) stabförmig ausgebildet ist.

4. Steck- und Ziehhilfe nach einem der vorhergehenden Ansprüche,
dadurch **gekennzeichnet,**
daß das obere Ende der Verlängerung (4) abgesetzt ausgebildet ist.

5. Steck- und Ziehhilfe nach einem der vorhergehenden Ansprüche,
dadurch **gekennzeichnet,**
daß das obere Ende der Verlängerung (4) abgerundet und formschlüssig zu einer Vertiefung (6) im Griffteil (3) ausgebildet ist.

6. Steck- und Ziehhilfe nach einem der vorhergehenden Ansprüche,
dadurch **gekennzeichnet,**
daß die Verlängerung (4) einen Rastbereich mit punktoder ringförmigen Rastelementen (8) aufweist und daß in dem Rastbereich ein Hohlraum (10) in der Verlängerung (4) vorhanden ist.

7. Steck- und Ziehhilfe nach einem der vorhergehenden Ansprüche,
dadurch **gekennzeichnet,**
daß die Rastelemente (8) im oberen und unteren Bereich der Führung der Verlängerung (4) angeordnet sind und die Verlängerung (4) dazu formschlüssige Eingriffsbereiche, insbesondere Vertiefungen oder Löcher, aufweist.

8. Steck- und Ziehhilfe nach einem der vorhergehenden Ansprüche,
dadurch **gekennzeichnet,**
daß die Rastelemente eine Federvorspannung aufweisen.

9. Steck- und Ziehhilfe nach einem der vorhergehenden Ansprüche,
dadurch **gekennzeichnet,**
daß das Formteil (1) und/oder die Verlängerung (4) aus Druckguß ausgebildet sind.

10. Steck- und Ziehhilfe nach einem der vorhergehenden Ansprüche,
dadurch **gekennzeichnet,**
daß das Formteil (1) und/oder die Verlängerung (4) aus Kunststoff ausgebildet sind.

## Claims

1. An insertion and removal aid, particularly for the fitting of electronic subassemblies in systems, with a locking part (2), a gripping part (3) and an extension (4), and in which said locking part (2) and said gripping part (3) form a molding and said gripping part (3) comprises a recess (5) with an extension (4) which can be slid in and out and which in the slid-in state is received in said complementary-shaped recess (5),
**characterized** in that
said extension (4) comprises at an upper end a cylindrical handle (7) which in the slid-in state is positively received in a roughly semicircular depression (6) of said gripping part (3), and that
said extension (4), which can be slid out, is secured in both end positions by means of locking elements (8) which engage in complementarily arranged recesses (9) of the guide of said extension (4).

2. An insertion and removal aid according to claim 1,
**characterized** in that
said extension (4) extends over virtually the entire width of said gripping part (3).

3. An insertion and removal aid according to claim 1 or 2,
**characterized** in that
said extension (4) is rod-like constructed.

4. An insertion and removal aid according to one of the preceding claims,
**characterized** in that
the upper end of said extension (4) is offset.

5. An insertion and removal aid according to one of the preceding claims,
**characterized** in that
the upper end of said extension (4) is rounded and constructed positively with respect to a depression (6) in said gripping part (3).

6. An insertion and removal aid according to one of the preceding claims,
**characterized** in that
said extension (4) comprises a locking region with punctiform or circular locking elements (8), and that there is a cavity (10) in the locking region of said extension (4).

7. An insertion and removal aid according to one of the preceding claims,
**characterized** in that
said locking elements (8) are located in the upper and lower area of the guide of said extension (4) and for this purpose said extension (4) has positive engagement areas, particularly depressions or holes.

8. An insertion and removal aid according to one of the preceding claims,
**characterized** in that
said locking elements have a spring bias.

9. An insertion and removal aid according to one of the preceding claims,
**characterized** in that
said molding (1) and/or said extension (4) are constructed from a pressure die casting.

10. An insertion and removal aid according to one of the preceding claims,
**characterized** in that
said molding (1) and/or said extension (4) are made of plastic.

## Revendications

1. Moyens d'insertion et d'extraction, en particulier pour l'installation de composants électroniques dans des sous-ensembles, comprenant une pairie de verrouillage (2), une partie formant poignée (3) et un prolongement (4), dans lesquels la partie de verrouillage (2) et la partie formant poignée (3) forment une pièce moulée et la partie formant poignée (3) présente un évidement (5) avec un prolongement extensible et rétractable (4) qui est logé, à l'état rentré, dans l'évidement (5) de configuration complémentaire, ***caractérisés en ce que*** le prolongement (4) présente à une extrémité supérieure une poignée (7) en forme de cylindre qui, à l'état rentré, est logée en engagement positif dans un renfoncement approximativement semi-circulaire (6) de la partie formant poignée (3), et ***en ce que*** le prolongement extensible (4) est immobilisé dans deux positions finales au moyens d'éléments d'encliquetage (8) qui s'enclenchent dans des évidements (9) de disposition complémentaire du guidage du prolongement (4).

2. Moyens d'insertion et d'extraction selon la Revendication 1, ***caractérisés en ce que*** le prolongement (4) s'étend sur pratiquement toute la largeur de la partie formant poignée (3).

3. Moyens d'insertion et d'extraction selon la Revendication 1 ou 2, ***caractérisés en ce que*** le prolongement (4) est conformé en tige.

4. Moyens d'insertion et d'extraction selon l'une des Revendications précédentes, ***caractérisés en ce que*** l'extrémité supérieure du prolongement (4) est conformée avec un épaulement.

5. Moyens d'insertion et d'extraction selon l'une des Revendications précédentes, ***caractérisés en ce que*** l'extrémité supérieure du prolongement (4) est arrondie et est conformée pour se mettre en engagement positif avec un renfoncement (6) prévu dans la partie formant poignée (3).

6. Moyens d'insertion et d'extraction selon l'une des Revendications précédentes, ***caractérisés en ce que*** le prolongement (4) présente une zone d'encliquetage avec des éléments d'encliquetage (8) ponctuels ou annulaires, et *en ce qu'un* espace vide (10) est présent dans le prolongement (4) dans la zone d'encliquetage.

7. Moyens d'insertion et d'extraction selon l'une des Revendications précédentes, ***caractérisés en ce que*** les éléments d'encliquetage (8) sont placés dans la partie supérieure et inférieure du guidage du prolongement (4) et le prolongement (4) présente des zones de prise permettant un engagement positif avec ceux-ci, en particulier des renfoncements ou des trous.

8. Moyens d'insertion et d'extraction selon l'une des Revendications précédentes, ***caractérisés en ce que*** les éléments d'encliquetage présentent une précontrainte élastique.

9. Moyens d'insertion et d'extraction selon l'une des Revendications précédentes, ***caractérisés en ce que*** la partie moulée (1) et/ou le prolongement (4) est formé par coulée sous pression.

10. Moyens d'insertion et d'extraction selon l'une des Revendications précédentes, ***caractérisés en ce que*** la partie moulée (1) et/ou le prolongement (4) est formé en matière synthétique.
